# EUROPEAN PATENT SPECIFICATION

(11) **EP 0 239 960 B1**
(45) Date of publication and mention of the grant of the patent: **01.06.1994**
(21) Application number: 87104625.6
(22) Date of filing: 27.03.1987
(51) Int. Cl.: H01L 29/72, H01L 29/54, H01L 29/08

(54) **Power transistor device**
Leistungstransistor
Transistor de puissance

(30) Priority: 31.03.1986 JP 70966/86
(43) Date of publication of application: 07.10.1987
(73) Proprietor: KABUSHIKI KAISHA TOSHIBA, Kawasaki-shi, Kanagawa-ken 210 (JP)
(72) Inventor: Emoto, Takao Patent Division, Minato-ku Tokyo 105 (JP); Shiomi,Takeo Patent Division, Minato-ku Tokyo 105 (JP); Takikawa,Osamu Patent Division, Minato-ku Tokyo 105 (JP); Saito, Masayuki Patent Division, Minato-ku Tokyo 105 (JP); Oodaira, Hirosi Patent Division, Minato-ku Tokyo 105 (JP)
(74) Representative: Lehn, Werner, Dipl.-Ing.

(56) References cited:
- EP-A- 0 141 075
- EP-A- 0 150 579
- AU-A- 340 003
- GB-A- 1 044 469
- ELECTRONIC DESIGN vol. 32, no. 2, January 1983, pages 37, 38, Waseca, MN Denville New Jersey, USA; F GOODENOUGH: "Bipolar power transistors take their cue from MOS technology"

## Description

The present invention relates to a power transistor device for power control and, more particularly, to a semiconductor device having a ballast resistance.

Normally, the application range of a bipolar transistor is restricted by a maximum rating, such as a maximum voltage, maximum current, maximum collector loss, and the like. Bipolar power transistors, which are subjected to high voltages and large currents, often break down, or their characteristics are impaired, even though they are used within the range of their maximum rating. Many people have studied this breakdown phenomenon, and it has been determined that a concentration of current can cause a local hot spot in a current path, and this induces local thermal runaway. In the state of local thermal runaway, the resistance of the hot spot as a semiconductor is decreased, due to an increase in temperature, and current flowing through the hot spot is increased. The temperature of the hot spot is further increased due to an increase in current, and this again induces a decrease in resistance. This cycle is repeated until the emitter-collector path is short-circuited, and hence, the transistor breaks down.

For this reason, in high-power transistors, an Area of Safety Operation (ASO) is rated in consideration of a secondary breakdown in addition to the maximum rating. It is important for developing high-power transistors to extend the ASO.

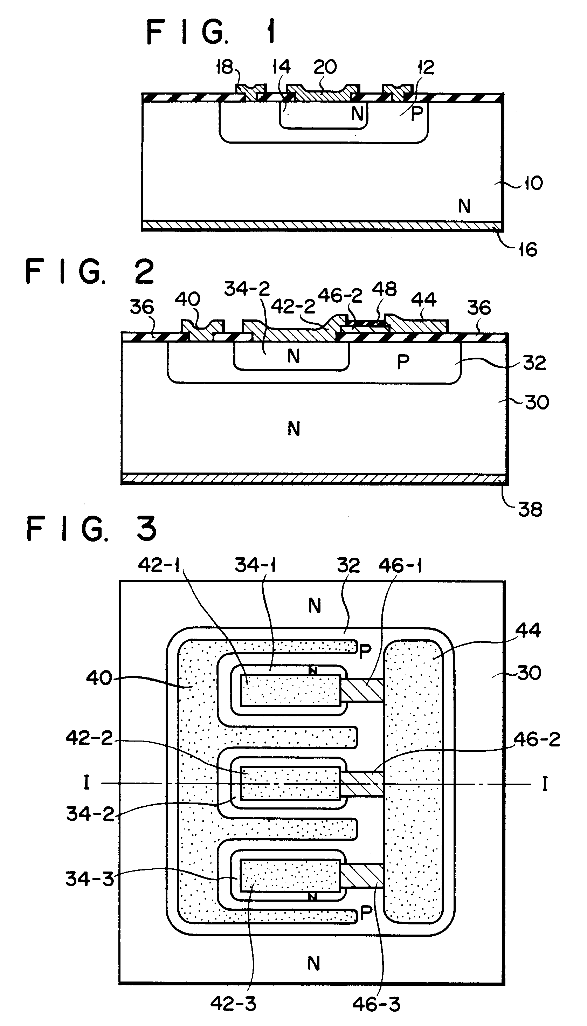

Fig. 1 shows an NPN power transistor having a known sectional structure. The transistor shown in Fig. 1 has n-type collector region or substrate 10, p-type base region 12 formed in the surface area of substrate 10, and n-type emitter region 14 formed in the surface area of base region 12. Collector electrode 16 of the transistor is formed in contact with the entire bottom surface of substrate 10. Base electrode 18 and emitter electrode 20 are formed in contact with part of the upper surface of region 12 and part of the upper surface of region 14, respectively. In the operation of this transistor, a current flowing across the collector and emitter is concentrated immediately below emitter region 14 in base region 12, due to the resistance in the lateral direction. If the emitter current is very large, a hot spot can easily occur near a base-emitter junction. If the hot spot actually does occur, local thermal runaway results. In a PNP power transistor, a hot spot is easily formed near the base-collector junction, and this induces local thermal runaway in the same manner as described above.

It is known that current gain h_{FE}, as the important characteristic of transistors, depends on the emitter injection efficiency and an effective emitter area, and becomes attenuated with a decrease in these factors. The emitter injection efficiency is considerably decreased when the operation of a transistor enters a large-current range. This is because the amount of carriers injected from emitter region 14 to base region 12 is increased. The effective emitter area is apparently decreased, since the emitter current is locally concentrated in base region 12 immediately below emitter region 14, due to the resistance in the lateral direction of base region 12.

Some countermeasures against the secondary breakdown of power transistors and a decrease in current gain have been proposed. For example, a uniform base type transistor, a triple-diffused transistor, a divided emitter type transistor, and the like are known. In the uniform base type transistor, an impurity is uniformly doped in a base region without a density gradient. In the triple-diffused transistor, a high-resistivity substrate is used as a collector region. In the divided emitter type transistor, a plurality of divided emitter regions are parallel-formed in the surface area of the base region in place of a single emitter region, and a ballast resistance is series-connected to the emitter or base region.

In particular, the divided emitter type transistor has a wide application range, can advantageously eliminate the above-mentioned defects, and is already commercially available. More specifically, the ballast resistance serves as a negative feedback resistance for suppressing an increase in emitter current, and an equally divided current flows through each divided emitter region. As a result, the temperature of the hot spot can be prevented from being increased. The ballast resistance normally comprises a semiconductor layer in which an impurity is doped, see EP-A-0 141 075. For example, B, P, SiC, Ta₂₀₃, Ta-SiO₂, and the like are used, and polysilicon is used for the semiconductor layer.

However, if the ballast resistance is an impurity-doped semiconductor layer, the following problems are posed. When a current flows through a semiconductor as a resistor material, this semiconductor is heated. The resistance of the semiconductor is undesirably decreased upon an increase in its temperature, and cannot be maintained constant. In power transistors in which a large current flows, the impurity-doped layer cannot satisfactorily function as the ballast resistance.

GB-A-1 044 469 describes a power transistor device including a semiconductor substrate serving as a collector region; a base region formed in a surface area of the substrate; and divided emitter regions formed in a surface area of the base region. The emitter electrodes are connected to a common emitter connection via resistors. The resistors are made from a mixture of a metal and a metal oxide.

It is an object of the present invention to provide a power transistor device having an extended range of safe operation.

The above object is solved by a power transistor device comprising: a semiconductor substrate serving as a collector region; a base region formed in a surface area of said semiconductor substrate; divided emitter regions formed in a surface area or said base region; ballast resistance means serving as a negative feedback resistance said balance resistance means being formed of a mixture of a metal and a metal oxide; and wiring means for wiring said collector, base and divided emitter regions via said ballast resistance means; **characterized in that** said ballast resistance means is formed of ruthenium oxide and oxide of at least one element selected from the group consisting of Mg, Ca, Sr and Ba with a positive temperature coefficient, and the atomic number of the oxide of the selected element is 0.6 to 2.0 times that of Ru. The ruthenium oxide material has a resistivity between a semiconductor and a metal and has an excellent stability against changes in temperature. This characteristic can easily satisfy requirements for designing or manufacturing the ballast resistance layer. The resistivity of the ruthenium oxide material can maintain its high resistance without considerably impairing the operation characteristics of the semiconductor device. As a result, the negative feedback effect of the ballast resistance layer can be improved. The stability of the ruthenium oxide material can minimize variations in resistance, even if the temperature of the ruthenium oxide material is considerably changed. Furthermore, the temperature coefficient of the ballast resistance layer can be set to be positive. Therefore, when the temperature of the ballast resistance layer is increased, thermal runaway of the power transistor device can be effectively prevented.

This invention can be more fully understood from the following detailed description when taken in conjunction with the accompanying drawings, in which:
Fig. 1 is a sectional view of a conventional bipolar power transistor;
Fig. 2 is a sectional view of a bipolar power transistor according to an embodiment of the present invention;
Fig. 3 is a plan view of the bipolar power transistor shown in Fig. 2;
Fig. 4 shows a barrier metal additionally provided to the bipolar power transistor shown in Fig. 2; and
Fig. 5 is a plan view of a bipolar power transistor according to another embodiment of the present invention.

A material best suited for a ballast resistance for stabilizing a current flowing through a power transistor device will be examined first. The negative feedback effect of the ballast resistance becomes stronger as its resistance is increased, and an increase in current can be effectively suppressed. However, strengthening of the negative feedback effect must be restricted, since the following problems are posed. When the negative feedback effect is strengthened, an equivalent current gain of a semiconductor device including a ballast resistance is decreased, collector-emitter saturation voltage V_{CE}(sat) is increased, and power loss in the ballast resistance is increased. From the actual examination results, it was found that when the ballast resistance was set at several Ω to 100 Ω, the negative feedback effect could be improved without causing the above problems. In consideration of actual dimensions of a region where the ballast resistance is formed as a layer, resistivity ρ of a resistor material is preferably ρ = 10⁻² to 10⁻³ Ωcm or higher. In order to improve the reliability upon an increase in temperature, the ballast resistance layer is preferably formed of a material having a positive temperature coefficient. For example, a metal resistor material such as Ni-Cr (nickel-chromium alloy) has a positive temperature coefficient, but has a considerably small resistivity of 10⁻⁴ to 10⁻⁵ Ωcm. Thus, a desired ballast resistance layer is difficult to attain. On the other hand, a semiconductor material has a relatively high resistivity. However, the resistance of the ballast resistance layer formed of the semiconductor material is decreased upon an increase in temperature. For example, a polysilicon ballast resistance layer and an SiC ballast resistance layer respectively have temperature coefficients of -1,000 ppm/°C and -2,000 ppm/°C near their application temperature.

From the above findings, the present inventors concluded that a ruthenium oxide material is best suited for a ballast resistance material. In particular, a ruthenium oxide material including ruthenium oxide and element M (M is at least one of Mg, Ca, Sr, and Ba) has an excellent stability, and has an appropriately high resistivity. Therefore, a ballast resistance layer having a desired resistance and dimensions can be formed. If atomic ratio M/Ru element M to Ru contained in the ruthenium oxide material is set to be less than 2, a positive temperature coefficient of resistance can be set (see Japanese patent Disclosure No. 60-157884).

If the value of M/Ru is set to be less than 0.6, the resistivity is undesirably decreased, and a desired resistance cannot be obtained. Therefore, the atomic ratio M/Ru of M to Ru contained in the ruthenium oxide material falls within the range of 0.6 to 2.

An embodiment of the present invention will be described with reference to Figs. 2 and 3. Fig. 3 shows the planar structure of a bipolar power transistor, and Fig. 2 shows the sectional structure of the bipolar power transistor taken along line I - I in Fig. 3. The power transistor has n-type collector region or substrate 30, and p-type base region 32 formed in the surface area of substrate 30. The power transistor also has a large number of n-type divided emitter regions formed in the surface area of base region 32. Fig. 3 illustrates three divided emitter regions 34-1, 34-2, and 34-3 for the sake of simplicity. Insulating film 36 is formed as a protective layer for covering the surfaces of regions 32, 34-1, 34-2, and 34-3. Collector electrode 38 is formed in contact with the entire bottom surface of substrate 30. Base electrode 40 and emitter electrodes 42-1, 42-2, and 42-3 are formed in contact with part of base region 32 and part of emitter region 34, respectively. Emitter wiring layer 44 is formed on insulating film 36. Ballast resistance layers 46-1, 46-2, and 46-3 each comprise BaRuO₃ films having a predetermined thickness (e.g., 0.5 µm), and are formed on insulating film 36 in contact with emitter electrodes 42-1, 42-2, and 42-3 and emitter wiring layer 44. In formation of ballast resistance layers 46-1, 46-2, and 46-3, BaRuO₃ is deposited on insulating film 36 by the sputtering method or a CVD method. The BaRuO₃ film is selectively etched by photoetching using a resist pattern as a mask, and is left as ballast resistance layers 46-1, 46-2, and 46-3, having predetermined dimensions. Thereafter, insulating protective film 48 such as SiO₂, Si₃N₄, or the like is coated on ballast resistance layers 46-1, 46-2, and 46-3, as needed.

A current stabilization operation of the ballast resistance will be described hereinafter. While emitter currents flow through divided emitter regions 34-1, 34-2, and 34-3, if one of these currents, e.g., a current flowing through region 34-2, irregularly increases, a voltage drop in ballast resistance layer 46-2 electrically connected to divided emitter region 34-2 through emitter electrode 42-2 is increased, and the potential of emitter electrode 42-2 is increased with respect to that of emitter wiring layer 44. Thus, the base-emitter forward bias voltage is locally decreased, and hence, a current flowing through divided emitter region 34-2 is decreased. More specifically, ballast resistance layers 46-1, 46-2, and 46-3 serve to suppress an increase in emitter currents flowing therethrough.

Therefore, a large number of divided emitter regions can be maintained at a substantially equal potential, and the emitter currents can be distributed to prevent concentration. As a result, secondary breakdown does not easily occur, and an ASO can be extended.

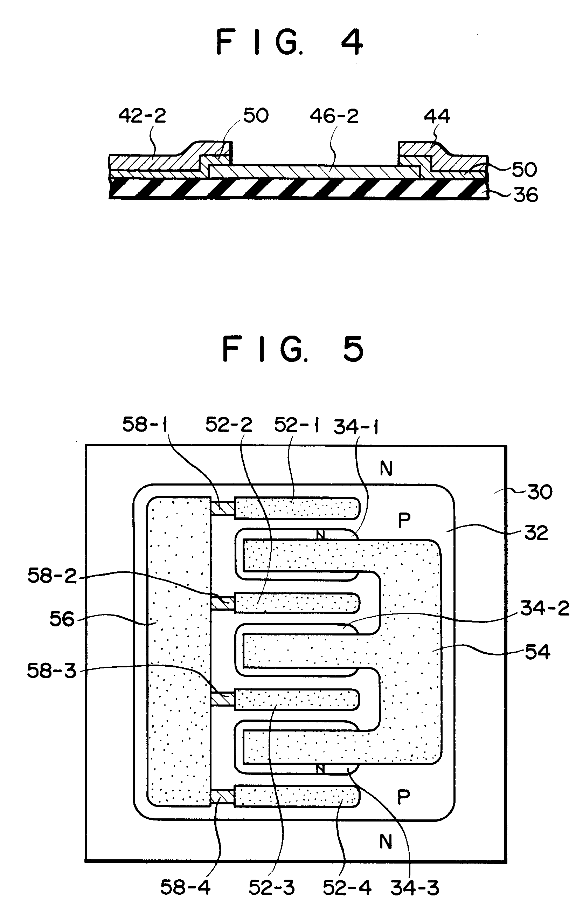

If the material of emitter electrodes 42-1, 42-2, and 42-3 and emitter wiring layer 44 is, e.g., an Aℓ film, Aℓ spreads into the ruthenium oxide material, and an insulator such as Aℓ₂O₃ is formed at their boundary, resulting in poor ohmic contact. In this case, high-melting point metal film 50 is formed as a barrier metal between ballast resistance layers 46-1, 46-2, and 46-3 and emitter electrodes 42-1, 42-2, and 42-3 and between ballast resistance layers 46-1, 46-2, and 46-3 and emitter wiring layer 44. Fig. 4 shows an example using a barrier metal and is an enlarged sectional view near ballast resistance layer 46-2. High-melting point metal film 50 (e.g., Ti, V, Cr, Zr, Nb, Mo, Hf, Ta, W, Ni, Pd, and Pt) must comprise a metal which does not react with metals such as Aℓ, Au, and ruthenium oxide at a thermal treatment temperature of about 500°C.

In this embodiment, the resistivity of the BaRuO₃ material is about 5 × 10⁻³ Ωcm (1 x 10⁻² to 10⁻³ Ωcm), and this value can be changed to some extent by changing the atomic ratio of Ba and Ru.

For example, a case will be assumed wherein resistance R of ballast resistance layers 46-1, 46-2, and 46-3 is set at 50 Ω. Resistance R is represented by formula R = ρ · ℓ/(t·w). In this formula, ρ is a resistivity, ℓ, t, and w are respectively a length, a thickness, and a width of ballast resistance layers 46-1, 46-2, and 46-3. If ρ = 5 x 10⁻³ Ωcm and thickness t is 0.5 µm, the ratio of length ℓ to width w can be a satisfactory value of 1 : 3. In this case, ballast resistance layers 46-1, 46-2, and 46-3 are set to have a temperature coefficient of about +800 ppm/°C. In a semiconductor device having the above ballast resistance layers 46-1, 46-2, and 46-3, even if a current concentration phenomenon occurs for any reason in the chip and the temperature of ballast resistance layers 46-1, 46-2, and 46-3 where the concentrated current flow is increased by 100°C, the resistance is increased by only 8%. Since ballast resistance layers 46-1, 46-2, and 46-3 have the positive temperature coefficient, the ballast resistance is increased due to an increase in temperature, and an effect for suppressing an increase in current can be enhanced. For example, in NPN power transistors which have a ballast resistance of 25 Ω, and 450 divided emitter regions, ASOs of a conventional structure and a structure of the present invention were measured and compared. When a 1-A emitter current was flowed through each divided emitter region by means of a single pulse having a pulse width of 300 ms, a collector-emitter voltage immediately before the transistor suffered from secondary breakdown was V_{CE} = 70 to 80 V in the conventional transistor, and about 150 V in the transistor of the present invention. More specifically, in the structure of the present invention, the ASO is widened to twice that of the conventional structure.

A bipolar power transistor according to a second embodiment of the present invention will be described with reference to Fig. 5. Fig. 5 shows the planar structure of the transistor. The same reference numerals in Fig. 5 denote the same parts as in the above embodiment, and a detailed description thereof will be omitted. In this embodiment, base electrodes 52-1, 52-2, 52-3, and 52-4 are formed in contact with base region 32 near divided emitter regions 34-1, 34-2, and 34-3. Emitter electrode 54 is formed in contact with divided emitter regions 34-1, 34-2, and 34-3. Base wiring layer 56 is formed on insulating film 36. Ballast resistance layers 58-1, 58-2, 58-3, and 58-4 are formed on insulating film 36 and in contact with base wiring layer 56 and base electrodes 52-1, 52-2, 52-3, and 52-4. The effect of ballast resistance layers 58-1, 58-2, 58-3, and 58-4 is basically the same as that in the first embodiment. If current concentration occurs in any of divided emitter regions 34-1, 34-2, and 34-3 and a base current flowing through a base electrode adjacent to the divided emitter region is increased, concentration of the emitter current can be suppressed by the negative feedback effect of the ballast resistance series-connected thereto. Since the base current of a transistor is normally small, e.g., 1/10 to 1/1,000 of the emitter current, this effect can be obtained in relatively small ballast resistance layers 58-1, 58-2, 58-3, and 58-4.

In the above embodiments, BaRuO₃ is used as the ruthenium oxide material. If Mg, Ca, Sr, and the like were used in place of Ba, satisfactory test results with excellent stability would be obtained over both long and short periods.

The present invention can be applied to other semiconductor devices which have a ballast resistance and cause the negative feedback effect utilizing a voltage drop. The technique of the present invention can be used in part of a power IC or in a hybrid device.

## Claims

1. A power transistor device comprising:
a semiconductor substrate (30) serving as a collector region;
a base region (32) formed in a surface area of said semiconductor substrate (30);
divided emitter regions (34-1 to 34-3) formed in a surface area or said base region (32);
ballast resistance means (46-1 to 46-3; 58-1 to 58-4) serving as a negative feedback resistance said balance resistance means (46-1 to 46-3, 58-1 to 58-4) being formed of a mixture of a metal and a metal oxide; and
wiring means (38, 40, 42-1 to 42-3, 44, 50; 38, 50, 54, 52-1 to 52-4, 54) for wiring said collector, base and divided emitter regions (30, 32, 34-1 to 34-3) via said ballast resistance means (46-1 to 46-3; 58-1 to 58-4);
**characterized in that**
said ballast resistance means (46-1 to 46-3; 58-1 to 58-4) is formed of ruthenium oxide and oxide of at least one element selected from the group consisting of Mg, Ca, Sr and Ba with a positive temperature coefficient, and
the atomic number of the oxide of the selected element is 0.6 to 2.0 times that of Ru.

2. A power transistor device according to claim 1, **characterized in that** said wiring means includes an emitter wiring layer (44) and a plurality of emitter electrodes (42-1 to 42-3) formed on said divided emitter regions (34-1 to 34-3), and said ballast resistance means includes a plurality of ballast resistance layers (46-1 to 46-3) each connected between a different one of said emitter electrodes (42-1 to 42-3) and said emitter-wiring layer (44).

3. A power transistor device according to claim 2, **characterized in that** said ballast resistance layers contact with said emitter-wiring layer (44) and said emitter electrodes (42-1 to 42-3) via barrier metal films (50) of a high-melting point metal.

4. A power transistor device according to claim 3, **characterized in that** said high-melting point metal is one element selected from the group consisting of Ti, V, Cr, Zr, Nb, Mo, Hf, Ta, W, Ni, Pd and Pt.

5. A power transistor device according to claim 1, **characterized in that** said wiring means includes a base-wiring layer (56) and a plurality of base electrodes (52-1 to 52-4) formed on the portions of said base region adjacent to said divided emitter regions (34-1 to 34-3) and said ballast resistance means includes a plurality of ballast resistance layers (58-1 to 58-4), each connected between a different one of said base electrodes (52-1 to 52-4) and said base-wiring layer (56).

6. A power transistor device according to claim 5, **characterized in that** said ballast resistance layers contact with said base-wiring layer (56) and said base electrodes (52-1 to 52-4) via barrier metal films (50) of a high-melting point metal.

7. A power transistor device according to claim 6, **characterized in that** said high-melting point metal is one element selected from the group consisting of Ti, V, Cr, Zr, Nb, Mo, Hf, Ta, W, Ni, Pd and Pt.

## Patentansprüche

1. Leistungstransistor, mit:
einem Halbleitersubstrat (30), das als Kollektorzone dient;
einer in einem Oberflächenbereich des Halbleitersubstrats (30) ausgebildeten Basiszone (32);
in einem Oberflächenbereich der Basiszone (32) ausgebildeten Teilemitterzonen (34-1 bis 34-3);
einer Ballastwiderstandseinrichtung (46-1 bis 46-3; 58-1 bis 58-4), die als negativer Rückkopplungswiderstand dient, wobei die Ballastwiderstandseinrichtung (46-1 bis 46-3; 58-1 bis 58-4) aus einer Mischung aus einem Metall und einem Metalloxid besteht; und
einer Verdrahtungseinrichtung (38, 40, 42-1 bis 42-3, 44, 50; 38, 50, 54, 52-1 bis 52-4, 54) zur Verdrahtung des Kollektors, der Basis und der Teilemitterzonen (30, 32, 34-1 bis 34-3) über die Ballastwiderstandseinrichtung (46-1 bis 46-3; 58-1 bis 58-4);
dadurch gekennzeichnet, daß
die Ballastwiderstandseinrichtung (46-1 bis 46-3; 58-1 bis 58-4) aus Rutheniumoxid und einem Oxid von mindestens einem Element aus der, aus Mg, Ca, Sr und Ba bestehenden Gruppe mit einem positiven Temperaturkoeffizienten, hergestellt wird, und
die Ordnungszahl des Oxids des ausgewählten Elements die 0,6- bis 2,0-fache der von Ru ist.

2. Leistungstransistor nach Anspruch 1, dadurch gekennzeichnet, daß die Verdrahtungseinrichtung eine Emitterverdrahtungsschicht (44) und eine Vielzahl von Emitterelektroden (42-1 bis 42-3 aufweist, die auf den Teilemitterzonen (34-1 bis 34-3) ausgebildet sind, und daß die Ballastwiderstandseinrichtung eine Vielzahl von Ballastwiderstandsschichten (46-1 bis 46-3) aufweist, von denen jede zwischen einer unterschiedlichen Emitterelektrode (42-1 bis 42-3) und der Emitterverdrahtungsschicht (44) angeschlossen ist (44).

3. Leistungstransistor nach Anspruch 2, dadurch gekennzeichnet, daß die Ballastwiderstandsschichten mit der Emitterverdrahtungsschicht (44) und mit den Emitterelektroden (42-1 bis 42-3) über einen Barrierenmetallfilm (50) aus einem Metall mit hohem Schmelzpunkt in Kontakt stehen.

4. Leistungstransistor nach Anspruch 3, dadurch gekennzeichnet, daß das Metall mit hohem Schmelzpunkt, ein Metall ist, das aus der, aus Ti, V, Cr, Zr, Nb, Mo, Hf, Ta, W, Ni, Pd und Pt bestehenden Gruppe, ausgewählt wird.

5. Leistungstransistor nach Anspruch 1, dadurch gekennzeichnet, daß die Verdrahtungseinrichtung eine Basisverdrahtungsschicht (56) und eine Vielzahl von Basiselektroden (52-1 bis 52-4) aufweist, die auf denjenigen Abschnitten der Basiszonen ausgebildet sind, die zu den Teilemitterzonen (34-1 bis 34-3) benachbart liegen, und daß die Ballastwiderstandseinrichtung eine Vielzahl von Ballastwiderstandsschichten (58-1 bis 58-4) aufweist, von denen jede zwischen einer unterschiedlichen Basiselektrode (52-1 bis 52-4) und der Basisverdrahtungsschicht (56) angeschlossen ist (56).

6. Leistungstransistor nach Anspruch 5, dadurch gekennzeichnet, daß die Ballastwiderstandsschichten mit der Basisverdrahtungsschicht (56) und mit den Basiselektroden (52-1 bis 52-4) über Barrierenmetallfilme (50) aus einem Metall mit hohem Schmelzpunkt in Kontakt stehen.

7. Leistungstransistor nach Anspruch 6, dadurch gekennzeichnet, daß das Metall mit hohem Schmelzpunkt, ein Metall ist, das aus der, aus Ti, V, Cr, Zr, Nb, Mo, Hf, Ta, W, Ni, Pd und Pt bestehenden Gruppe, ausgewählt wird.

## Revendications

1. Dispositif de transistor de puissance comprenant :
un substrat semiconducteur (30) jouant le rôle de région de collecteur ;
une région de base (32) formée dans une aire de surface dudit substrat semiconducteur (30) ;
des régions d'émetteur divisées (34-1 à 34-3) formées dans une aire de surface de ladite région de base (32) ;
un moyen de résistance de stabilisation (46-1 à 46-3 ; 58-1 à 58-4) qui joue le rôle de résistance de retour négatif dudit moyen de résistance d'équilibrage (46-1 à 46-3, 58-1 à 58-4) qui est réalisé en un mélange d'un métal et d'un oxyde de métal ; et
un moyen de câblage (38, 40, 42-1 à 42-3, 44, 50 ; 38, 50, 54, 52-1 à 52-4, 54) pour câbler lesdites régions de collecteur, de base et d'émetteur divisées (30, 32, 34-1 à 34-3) via ledit moyen de résistance de stabilisation (46-1 à 46-3 ; 58-1 à 58-4),
caractérisé en ce que :
ledit moyen de résistance de stabilisation (46-1 à 46-3 : 58-1 à 58-4) est réalisé en oxyde de ruthénium et en oxyde d'au moins un élément choisi parmi le groupe comprenant le Mg, le Ca, le Sr et le Ba moyennant un coefficient de température positif ; et
le numéro atomique de l'oxyde de l'élément sélectionné vaut de 0,6 à 2,0 fois celui du Ru.

2. Dispositif de transistor de puissance selon la revendication 1, caractérisé en ce que ledit moyen de câblage inclut une couche de câblage d'émetteur (44) et une pluralité d'électrodes d'émetteur (42-1 à 42-3) formées sur lesdites régions d'émetteur divisées (34-1 à 34-3) et ledit moyen de résistance de stabilisation inclut une pluralité de couches de résistance de stabilisation (46-1 à 46-3) dont chacune est connectée entre l'une différente desdites électrodes d'émetteur (42-1 à 42-3) et ladite couche de câblage d'émetteur (44).

3. Dispositif de transistor de puissance selon la revendication 2, caractérisé en ce que lesdites couches de résistance de stabilisation entrent en contact avec ladite couche de câblage d'émetteur (44) et avec lesdites électrodes d'émetteur (42-1 à 42-3) via des films en métal barrière (50) en un métal à point de fusion élevé.

4. Dispositif de transistor de puissance selon la revendication 3, caractérisé en ce que ledit métal à point de fusion élevé est un élément choisi parmi le groupe qui comprend le Ti, le V, le Cr, le Zr, le Nb, le Mo, le Hf, le Ta, le W, le Ni, le Pd et le Pt.

5. Dispositif de transistor de puissance selon la revendication 1, caractérisé en ce que ledit moyen de câblage inclut une couche de câblage de base (56) et une pluralité d'électrodes de base (52-1 à 52-4) formées sur les parties de ladite région de base adjacentes auxdites régions d'émetteur divisées (34-1 à 34-3) et ledit moyen de résistance de stabilisation inclut une pluralité de couches de résistance de stabilisation (58-1 à 58-4) dont chacune est connectée entre différentes desdites électrodes de base (52-1 à 52-4) et ladite couche de câblage de base (56).

6. Dispositif de transistor de puissance selon la revendication 5, caractérisé en ce que lesdites couches de résistance de stabilisation entrent en contact avec ladite couche de câblage de base (56) et avec lesdites électrodes de base (52-1 à 52-4) via des films en métal barrière (50) en un métal à point de fusion élevé.

7. Dispositif de transistor de puissance selon la revendication 6, caractérisé en ce que ledit métal à point de fusion élevé est un élément choisi parmi le groupe qui comprend le Ti, le V, le Cr, le Zr, le Nb, le Mo, le Hf, le Ta, le W, le Ni, le Pd et le Pt.
